# EUROPEAN PATENT SPECIFICATION

(11) **EP 4 528 443 B1**
(45) Date of publication and mention of the grant of the patent: **01.07.2026**
(21) Application number: 24200057.8
(22) Date of filing: 12.09.2024
(51) Int. Cl.: G06F 3/041, H10K 59/80, H10K 102/00

(54) **DISPLAY DEVICE**
ANZEIGEVORRICHTUNG
DISPOSITIF D'AFFICHAGE

(30) Priority: 20.09.2023 KR 20230125581
(43) Date of publication of application: 26.03.2025
(60) Divisional application: 26179730.2
(73) Proprietor: LG Display Co., Ltd., Seoul 07336 (KR)
(72) Inventor: Shin, Jiyoon, 10845 Paju-si (KR)
(74) Representative: Cousens, Nico

(56) References cited:
- US-A1- 2020 152 707
- US-A1- 2022 344 441

## Description

### Field

The present disclosure relates to a display device, and more specifically, to a display device which may reduce moisture infiltration into a bendable area.

### Description of Related Art

Recent display devices that may display various information and interact with users viewing the information at the same time are required to have various sizes, shapes, and functions.

The display devices include liquid crystal display devices (LCD), electrophoretic display devices (EPD), and organic light-emitting display devices (Organic Light-Emitting Diode Display Device) (OLED).

The organic light-emitting display device is a self light-emitting display device. Unlike a liquid crystal display device (LCD), the organic light-emitting display device does not require a separate light source and may be manufactured in a lightweight and thin form. Furthermore, the organic light-emitting display device is not only advantageous in terms of power consumption due to low-voltage operation, but also have excellent color reproduction, response speed, viewing angle, and contrast ratio (CR), and thus is being studied as a next-generation display.

The organic light-emitting display device uses a plurality of thin film transistors (TFT) to control current flowing through organic light-emitting diodes to display an image. Further, a structure in which a touch electrode is formed on a display panel to enable touch operation is applied to the organic light-emitting display device.

The organic light-emitting display device may be folded or bent into various shapes using a flexible substrate.

In order to enlarge a display area of the display device and reduce a bezel area, a pad to which a printed circuit board is connected may be disposed on an opposite surface to a surface having the display area. 9

For this purpose, a bendable area where the flexible substrate is bent may be defined.

In this bendable area, the flexible substrate and a wiring and insulating films disposed on the substrate may be bent together. To bend the display panel, a minimum amount of the insulation film and the wiring may be disposed in the bendable area. A connection area for connecting the wiring of the bendable area to a wiring of the display area and the pad is adjacent to the bendable area and thus may be vulnerable to moisture infiltration.

US 2020/152707 A1 in its abstract states: 'A display device prevents cracks from spreading to an active area. The display device includes a substrate including an active area and a non-active area having a bending area, a thin-film transistor disposed in the active area, a light-emitting element disposed in the active area and connected to the thin-film transistor, an encapsulation layer disposed on the light-emitting element, a touch sensor disposed on the encapsulation layer, a touch pad disposed in the non-active area, a first routing line connecting the touch sensor to the touch pad via a second routing line in the bending area, and a crack prevention layer disposed on the second routing line in the bending area. Thus, the crack prevention layer is capable of preventing the occurrence of cracks in the bending area BA, thus preventing cracks from spreading to the active area AA.'

US 2022/344441 A1 in its abstract states: 'A display apparatus in which wiring in a bending area cracks less includes a substrate including a display area, a peripheral area, and a bending area which is at least a portion of the peripheral area that is bendable, an inorganic insulating layer arranged on the substrate and overlapping the display area and the peripheral area and defining an opening, a pixel circuit in the display area, a planarization insulating layer on the pixel circuit, a pad portion on an end of the peripheral area, a first organic layer arranged in the bending area and including the same material as a material included in the planarization insulating layer, and a connection wire extending on the pad portion. The connection wire includes first metal patterns under the first organic layer, and second metal patterns on the first organic layer and electrically connected to the first metal patterns.'

### SUMMARY

The bendable area of the display panel of the display device and the connection area adjacent thereto may be vulnerable to moisture infiltration. The invention is set out in the appended set of claims.

Accordingly, the inventors of the present disclosure have invented a display device in which an insulating film structure is disposed in a touch area in a display panel including the touch area, thereby preventing moisture penetration into the bendable area of the display panel.

A purpose according to an embodiment of the present disclosure is to provide a display device in which an inorganic insulating film layer of the touch area blocks a moisture penetration path into an underlying connection area.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

A display device according to an embodiment of the present disclosure includes a substrate; a display area and a non-display area disposed on the substrate; a plurality of sub-pixels disposed in the display area, each sub-pixel including at least one transistor; a bendable area disposed in the non-display area; a connection area disposed between the bendable area and the display area; a light-emitting layer connected to the transistor; an encapsulation layer disposed on the light-emitting layer; a touch electrode disposed on the encapsulation layer; a touch planarization layer disposed on the touch electrode; and a partitioning wall disposed in the bendable area and adjacent to the connection area, wherein the partitioning wall and the touch planarization layer are made of the same material.

Specific details of other embodiments are included in the detailed description and drawings.

The display device according to an embodiment of the present disclosure may prevent the moisture infiltration into the connection area using the insulating film structure of the touch area in the bendable area.

Effects of the present disclosure are not limited to the effects as mentioned above, and other effects as not mentioned will be clearly understood by those skilled in the art from the descriptions below.

In addition to the above effects, specific effects of the present disclosure will be described together while describing specific details for carrying out the present disclosure.

### BRIEF DESCRIPTION OF DRAWINGS

FIG. 1 is a block diagram showing a display device according to an embodiment of the present disclosure.
FIG. 2 is a circuit diagram of a sub-pixel of a display device according to an embodiment of the present disclosure.
FIG. 3 is a plan view of a display panel of a display device according to an embodiment of the present disclosure.
FIG. 4 is an enlarged plan view of an area A of the display device of FIG. 3.
FIG. 5 is a cross-sectional view of a display device according to an embodiment of the present disclosure.
FIG. 6 is a cross-sectional view of a display panel according to an embodiment of the present disclosure as cut along a line B-B' in FIG. 4.
FIG. 7 is a cross-sectional view of a display panel according to an embodiment of the present disclosure as cut along a line C-C' in FIG. 4.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to entirely inform the scope of the present disclosure to those of ordinary skill in the technical field to which the present disclosure belongs, and the present invention is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives and modifications as may be included within the scope of the present invention as defined by the appended claims.

A shape, a size, a ratio, an angle, a number, etc. disclosed in the drawings for describing embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to" another element or layer, it may be directly on, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like is disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like may be disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is separate explicit description thereof.

It will be understood that when an element or layer is referred to as being "connected to" another element or layer, it may be directly on, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

The features of the various embodiments of the present disclosure may be partially or entirely combined with each other, and may be technically associated with each other or operate with each other. The embodiments may be implemented independently of each other and may be implemented together in an association relationship.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for describing embodiments.

Further, in a specific case, a term may be arbitrarily selected by the applicant, and in this case, the detailed meaning thereof will be described in a corresponding description section. Therefore, the terms used in the description below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B through another node unless a phrase 'immediately transferred' or 'directly transferred' is used.

As used herein, the term "display device" may include, in a narrow sense, a display device including a liquid crystal module (LCM), an organic light-emitting diode (OLED) module, or a quantum dot (QD) module including a display panel and a driver for driving the display panel. Moreover, the display device may include, in a broad sense, a laptop computer, a television, a computer monitor, an automotive device or an equipment display for a vehicle, a set electronic device, a set device or a set apparatus including a complete product or a final product including the LCM, the OLED module, or the QD module.

Therefore, the display device in accordance with the present disclosure may include, in the narrow sense, a display device itself including, for example, the LCM, the OLED module, QD module, etc., and may include, in a broad sense, the set device as an application product or an end-user device including a complete product or a final product including the LCM, the OLED module, or the QD module.

Moreover, in some cases, the LCM, OLED module, or QD module composed of the display panel and the driver may be expressed as "display device" in a narrow sense. The electronic device as a complete product including the LCM, OLED module or QD module may be expressed as "set device" in a broad sense. For example, the display device in the narrow sense may include a display panel such as a liquid crystal panel, an organic light-emitting display panel, or a quantum dot display panel, and a source PCB as a controller for driving the display panel. The set device in the broad sense may include a display panel such as a liquid crystal panel, an organic light-emitting display panel, or a quantum dot display panel, a source PCB as a controller for driving the display panel, and a set PCB as a set controller that is electrically connected to the source PCB and controls the set device.

As used herein, the display panel may be of any type of the display panels such as a liquid crystal display panel, an organic light-emitting diode (OLED) display panel, a quantum dot (QD) display panel, and an electroluminescent display panel, etc. The display panel used in the disclosure may be not limited to a specific display panel including a flexible substrate for the OLED display panel and an underlying back plate support structure and having a bendable bezel. Moreover, the display panel used in the display apparatus according to an embodiment of the present disclosure is not limited to a shape or a size of the display panel.

Hereinafter, a display device according to each of various embodiments of the present disclosure will be described with reference to the drawings.

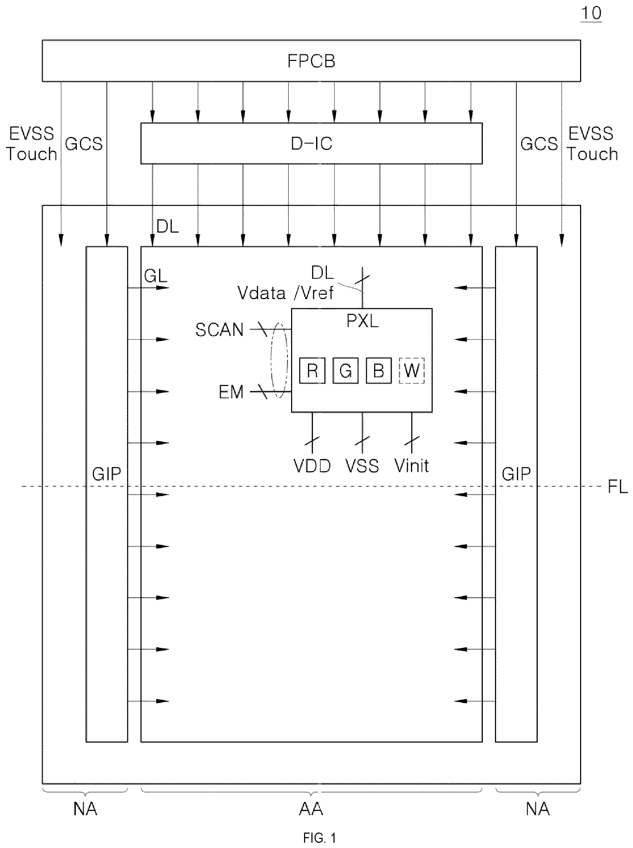

FIG. 1 is a block diagram illustrating a display device according to an embodiment of the present disclosure.

A display device 10 may include a plurality of areas. For example, the display device 10 may include one or more display areas AA where an image is displayed, and a pixel PXL may be formed in the display area AA. One or more non-display areas NA in which an image is not displayed may include a driver circuit area and a dam area, and may be disposed on one side of the display area AA. For example, the non-display area NA may be adjacent to one or more sides of the display area AA.

Referring to FIG. 1, the non-display area NA may surround the display area AA of a rectangular shape. However, it should be understood that a shape of the display area AA and a position of the non-display area NA adjacent to the display area AA are not specifically limited to those in the display device 10 as shown in FIG. 1. Each of the display area AA and the non-display area NA may have any shape. Examples of these shapes may include a pentagon, a hexagon, a circle, an oval, etc. An embodiment of the present disclosure is not limited thereto.

The pixel PXL in the display area AA includes sub-pixels. The sub-pixels may display colors such as red (R), green (G), blue (B), and white (W). Moreover, each pixel PXL or sub-pixel may be associated with a pixel circuit including one or more thin-film transistors (TFTs) which are disposed on a substrate of the display device 10. Each pixel circuit may be electrically connected to a gate line GL and a data line DL to communicate with one or more driver circuits, for example, a gate driver GIP and a data driver D-IC disposed in the non-display area NA of the display device 10.

One or more driver circuits may be implemented as TFTs disposed in the non-display area NA as shown in FIG. 1. For example, the gate driver GIP may be implemented using a plurality of TFTs on the substrate of the display device 10. Non-limiting examples of circuits that may be implemented as the TFTs of the substrate include an inverter circuit, a multiplexer, and an ESD (electro-static discharge) circuit. An embodiment of the present disclosure is not limited thereto.

Some driver circuits may be provided as IC (integrated circuit) chips, and may be mounted in the non-display area NA of the display device 10 using a COG (chip-on-glass) or in other similar schemes. Moreover, some driver circuits may be mounted on another substrate, and may be coupled to a connection interface (pads/bumps, pins) disposed in the non-display area NA using a printed circuit board such as a flexible PCB (flexible printed circuit board: FPCB), COF (chip-on-film), TCP (tape-carrier-package) or other suitable schemes.

In embodiments of the present disclosure, at least two different types of TFTs are disposed in a TFT substrate for display. The types of TFTs employed in a portion of the pixel circuit and a portion of the driver circuit may vary according to requirements of display.

For example, the pixel circuit may be implemented as a TFT (oxide TFT) with an oxide active layer. The driver circuit may be implemented as a TFT (LTPS TFT) with a low-temperature polycrystalline silicon active layer and a TFT with an oxide active layer. Unlike the LTPS TFTs, the oxide TFTs do not suffer from pixel-to-pixel threshold voltage Vth variation. A uniform threshold voltage Vth may also be obtained in an array of pixel circuits for display. The uniformity problem of the threshold voltages Vth of the TFTs implementing the driver circuit will have less direct impact on the luminance uniformity of the pixels.

Using the driver circuits on the substrate to be implemented as the LTPS TFTs, signals and data may be provided to pixels at a higher clock than that when all TFTs in the TFT panel are embodied as oxide TFTs. Therefore, the display device capable of high-speed operation may be realized without stains such as mura. For example, the advantages of the oxide TFT and the LTPS TFT are combined with the design of the TFT panel such that the oxide TFT and the LTPS TFT may be selectively used according to the advantage thereof.

Referring to FIG. 1, a low-potential voltage EVSS, a touch signal Touch, and a gate control signal GCS output from the flexible PCB (printed circuit board) (FPCB) are applied to the display panel, and a high-potential voltage is applied to the display panel through the data driver D-IC.

The gate driver GIP may be provided with a SCAN circuit connected to a switching transistor ST1 of the pixel PXL for transmitting a signal for turning on/off the switching transistor ST1 thereto, and an EM circuit connected to a light-emission signal line EM of the pixel PXL.

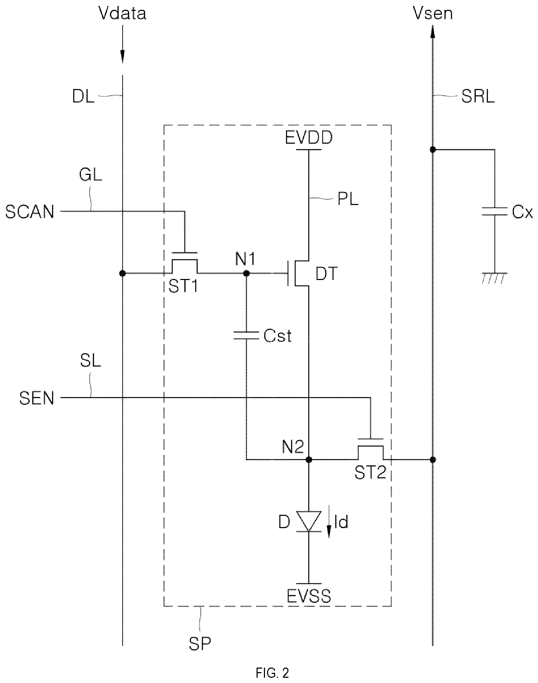

FIG. 2 illustrates a sub-pixel circuit that may be used in embodiments of the present disclosure. FIG. 2 illustrates an example in which the display device has a 3T1C structure including three thin-film transistors and one storage capacitor. However, the display device of the present disclosure is not limited to this structure, and may have various structures such as 4T1C, 5T1C, 6T1C, 7T1C, 8T1C, 4T2C, 5T2C, 6T2C, 7T2C, and 8T2C.

Referring to FIG. 2, the display device 10 according to an embodiment of the present disclosure may include the gate line GL, the data line DL, a power line PL, and a sensing line SL. Each sub-pixel SP may include a first switching thin-film transistor ST1, a second switching thin-film transistor ST2, a driving thin-film transistor DT, a light-emitting element D, and a storage capacitor Cst. However, embodiments of the present disclosure are not limited thereto.

The light-emitting element D includes an anode electrode connected to a second node N2, a cathode electrode connected to an input of the low-potential driving voltage EVSS, and a light-emitting element layer disposed between the anode electrode and the cathode electrode. The light-emitting element D may be an organic light-emitting element. However, embodiments of the present disclosure are not limited thereto.

The driving thin-film transistor DT may control current Id flowing through the light-emitting element D based on a voltage difference Vgs between a voltage of a gate and that of a source. The driving thin-film transistor DT may include a gate electrode connected to a first node N1, a drain electrode connected to the power line PL so as to provide a high-potential driving voltage EVDD thereto, and a source electrode connected to the second node N2.

The storage capacitor Cst is disposed between and connected to the first node N1 and the second node N2. The storage capacitor Cst allows a predefined voltage to be maintained for one frame.

The first switching thin-film transistor ST1 may apply a data voltage Vdata charged in the data line DL to the first node N1 in response to a gate signal SCAN so as to turn on the driving thin-film transistor DT during an operation of the display panel. In this regard, the first switching thin-film transistor ST1 may include a gate electrode connected to the gate line GL for receiving the gate signal SCAN therefrom, a drain electrode connected to the data line DL for receiving the data voltage Vdata therefrom, and a source electrode connected to the first node N1.

The second switching thin-film transistor ST2 switches a current between the second node N2 and a sensing voltage read-out line SRL in response to a sensing signal SEN such that a source voltage of the second node N2 is stored in a sensing capacitor Cx of the sensing voltage read-out line SRL. The second switching thin-film transistor ST2 switches a current between the second node N2 and the sensing voltage read-out line SRL in response to the sensing signal SEN during an operation of a display panel PAN such that the source voltage of the driving thin-film transistor DT is reset with an initialization voltage Vpre. A gate electrode of the second switching thin-film transistor ST2 is connected to the sensing line SL, a drain electrode thereof is connected to the second node N2, and a source electrode thereof is connected to the sensing voltage read-out line SRL.

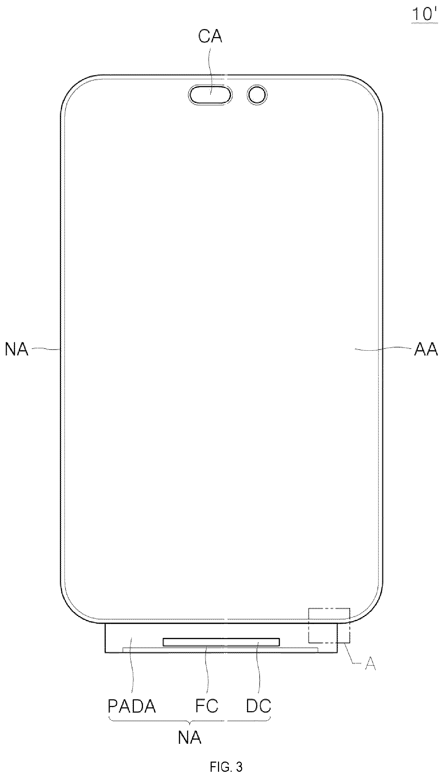

FIG. 3 is a plan view of a display panel of a display device according to an embodiment of the present disclosure.

A display panel 10' for displaying an image includes a display area AA and a non-display area NA on a substrate in a display device 10.

The non-display area NA of the display panel 10' may include an area surrounding the display area AA, a pad wiring area PADA, a FPCB connection area FC, and a D-IC connection area DC.

Furthermore, a camera hole CA where a camera may be disposed may be included in the display area AA.

The pad wiring area PADA, the FPCB connection area FC, and the D-IC connection area DC of the display panel 10' may be bent toward a back of the display panel 10' so as to be disposed under a back surface of the display panel 10'.

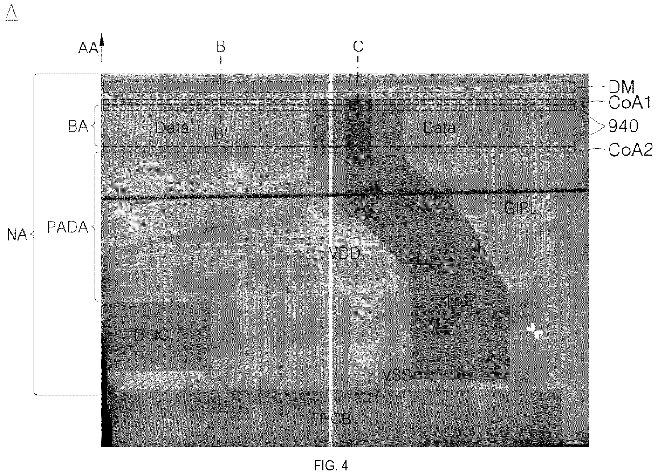

FIG. 4 is an enlarged plan view of an A area of the display device of FIG. 3.

Wirings extending from the display area AA into the non-display area NA may include data lines Data for transmitting a data signal of each pixel, a gate driving circuit line GIPL for transmitting a signal to a gate driving circuit GIP, a high-potential power voltage line VDD for transmitting a driving voltage, a low-potential power voltage line VSS, and a touch signal line ToE for transmitting a touch signal.

These signal and voltage lines may be electrically connected to a driving circuit chip D-IC and a flexible PCB FPCB.

The non-display area NA may include a bendable area BA and a dam area DM where a dam is disposed to define a position of an encapsulation layer to protect a light-emitting element of the display area AA.

Between the display area AA and the bendable area BA, a first connection area CoA1 may be disposed in which a contact hole for connecting the wiring extending from the display area AA into the non-display area NA to a bendable wiring of the bendable area BA is positioned.

In a second connection area CoA2 beyond the bendable area BA, a wiring of the pad wiring area PADA may be connected to the data driver D-IC and the flexible circuit board FPCB.

The bendable area BA may be designated as an area between the first connection area CoA1 and the second connection area CoA2. However, embodiments of the present disclosure are not limited thereto.

A plurality of partitioning walls 940 may be disposed in the bendable area BA. At least two of the plurality of partitioning walls 940 may be disposed in an area adjacent to the first connection area CoA1, while at least one of the plurality of partitioning walls 940 may be disposed in an area adjacent to the second connection area CoA2. However, embodiments of the present disclosure are not limited thereto.

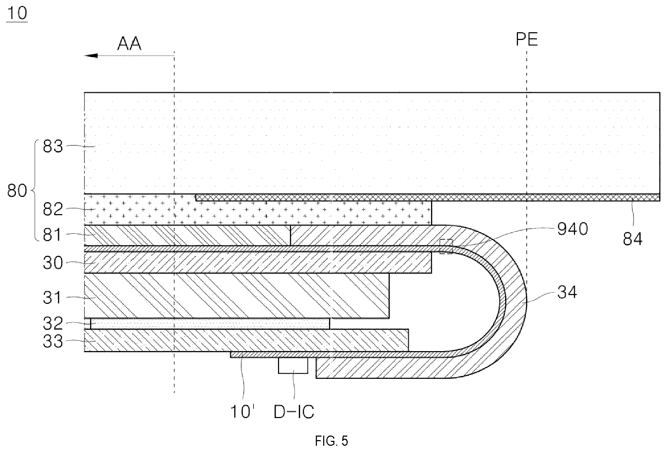

FIG. 5 is a cross-sectional view of a display device according to an embodiment of the present disclosure.

FIG. 5 schematically shows a cross-sectional view of an area where the display panel 10' is bent in the display device 10.

A first backplate 30 and a second backplate 33 that support the display panel 10' are attached to a bottom of the display panel 10'. The first backplate 30 may be disposed in the display area AA and a connection area, while the second backplate 33 may be spaced apart from the first backplate 30 by a certain distance and may be disposed in the pad wiring area PADA, the data driver D-IC area, and the flexible circuit board FPCB area.

In a spacing between the first backplate 30 and the second backplate 33, the display panel 10' may be bent so that a lower surface of the first backplate 30 and a lower surface of the second backplate 33 face each other.

A fixing member 31 may be disposed under the first backplate 30. The fixing member 31 may include an adhesive and a heat dissipation sheet, and may include a metal layer capable of reflecting external light therefrom. However, embodiments of the present disclosure are not limited thereto.

An adhesive member 32 may be disposed under the fixing member 31 to connect the fixing member 31 and the second backplate 33 to each other. The adhesive member 32 may be embodied as a double-sided tape, a double-sided foam adhesive tape, or a double-sided foam adhesive pad.

The bendable area BA of the display panel 10' may include an area where the partitioning wall 940 is disposed, and the bendable protective layer 34 may be disposed to overlap the partitioning wall 940. The bendable protective layer 34 may include a polymer material and may prevent moisture penetration into the bendable area BA.

A cover window 80 may be disposed on top of the display panel 10'.

The cover window 80 may include an optical film 81, an adhesive 82, and an upper substrate 83. The optical film 81 may include a polarizing film (POL). Embodiments of the present disclosure are not limited thereto.

The upper substrate 83 may extend such that an end thereof is disposed outwardly beyond an end PE of the bent area of the display panel 10'. A black ink 84 may be applied on the upper substrate 83 in an aera corresponding to the non-display area NA of the display panel 10' to prevent light leakage.

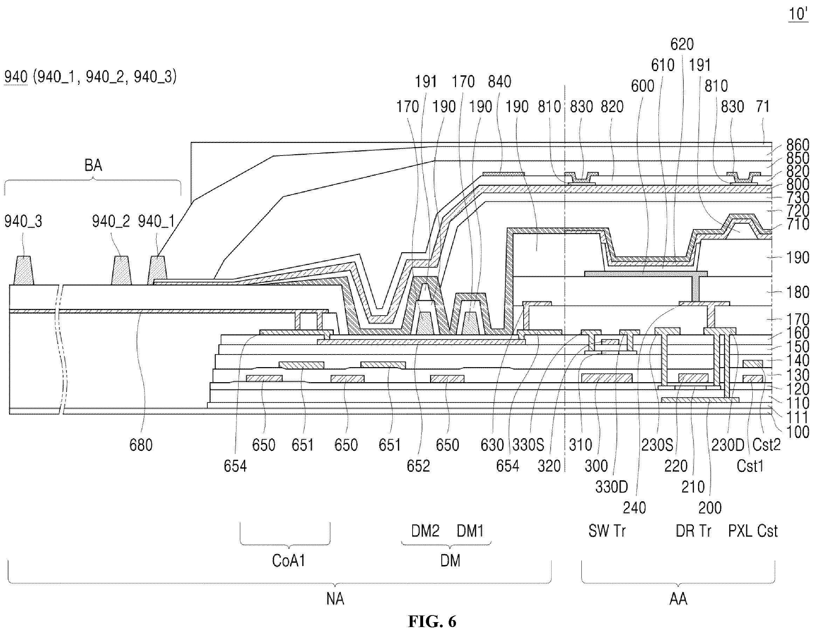

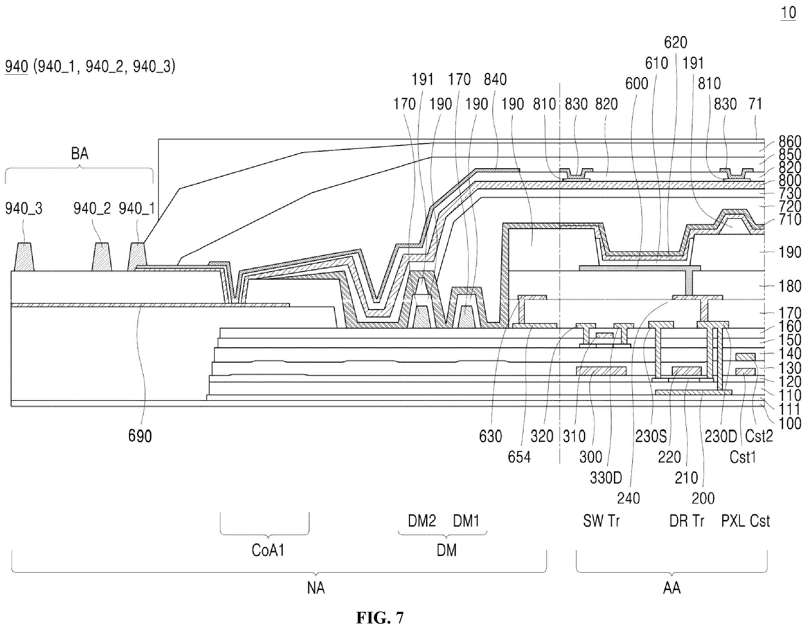

FIG. 6 is a cross-sectional view of a display panel according to an embodiment of the present disclosure as cut along a line B-B' in FIG. 4. FIG. 7 is a cross-sectional view of a display panel according to an embodiment of the present disclosure as cut along a line C-C' in FIG. 4. FIG. 6 and FIG. 7 show a flat state of the display panel 10' before it is bent, and schematically show the data line Data for transmitting the data signal to each pixel.

The substrate 100 of the display device according to an embodiment of the present disclosure may be composed of a first substrate and a second substrate, and an intermediate layer between the first substrate and the second substrate.

Each of the first substrate and the second substrate may be made of at least one of polyimide, polyethersulfone, polyethylene terephthalate, and polycarbonate. Embodiments of the present disclosure are not limited thereto. When the substrate is made of a plastic material, a manufacturing process of the display device proceeds while a support substrate made of glass is disposed under the substrate. The support substrate may be released therefrom after the manufacturing process of the display device has been completed. Furthermore, after the support substrate has been released, a backplate (or a plate) for supporting the substrate may be disposed under the substrate. When the substrate is made of a plastic material, moisture may penetrate the substrate and travel to the thin film transistor or light-emitting element layer, thereby deteriorating the performance of the display device. The display device according to an embodiment of the present disclosure may include two substrates, that is, the first substrate and the second substrate made of the plastic material to prevent the performance of the display device from being deteriorated due to the moisture permeation. Further, the inorganic intermediate layer may be disposed between the first and second substrates such that he performance reliability of the product may be improved by preventing the moisture from penetrating the substrate. The intermediate layer may be made of an inorganic material. For example, the intermediate layer may be composed of a single layer or a multilayer made of silicon nitride (SiNₓ) or silicon oxide (SiOₓ). However, the present disclosure is not limited thereto.

The display device including the substrate 100 may include a plurality of areas. The areas may include the display area AA and the non-display area NA. However, the present disclosure consists of is not limited thereto.

A buffer layer 111 composed of a single layer or multiple layers made of silicon nitride (SiNₓ) or silicon oxide (SiOₓ) may be disposed in the display area AA and the non-display area NA and on one surface of the substrate 100. The buffer layer 111 may improve the adhesion between the layers formed on the buffer layer 111 and the substrate 100 and block various types of defect factors such as alkaline components leaking from the substrate 100. Furthermore, the buffer layer 111 may delay the diffusion of moisture or oxygen that has penetrated the substrate 100.

The buffer layer 111 may be omitted based on a type and a material of the substrate, a structure and a type of the thin film transistor, etc.

The transistors in the display area AA may include a switching transistor SW Tr or a driving transistor DR Tr for driving the pixel PXL.

A light blocking layer 200 may be disposed under the driving transistor DR Tr.

The light blocking layer 200 may be connected to a first drain electrode 230D of the driving transistor DR Tr. The light blocking layer 200 may prevent light from being directed to a first semiconductor layer 210 of the driving transistor DR Tr, and may be connected to the first drain electrode 230D to prevent a phenomenon in which parasitic carriers are accumulated in the first semiconductor layer 210, thereby causing a rapid increase in drain current, or a change in a threshold voltage due to this phenomenon.

The light blocking layer 200 may be composed of multiple layers including a first layer including titanium (Ti), which is the same material as a material of the first source electrode 230S and the first drain electrode 230D, and a second layer including at least one of molybdenum (Mo), copper (Cu), aluminum (Al), silver (Ag,) chromium (Cr), gold (Au), neodymium (Nd), and nickel (Ni). Embodiments of the present disclosure are not limited thereto.

A first insulating layer 110 may be disposed on the light blocking layer 200. The first insulating layer 110 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

The first semiconductor layer 210 of the driving transistor DR Tr of the display area AA may be disposed on the first insulating layer 110, and the first semiconductor layer 210 may overlap the light blocking layer 200.

The first semiconductor layer 210 may be made of low temperature polycrystalline silicon (LTPS).

A first gate insulating layer 120 may be disposed on the first semiconductor layer 210. The first gate insulating layer 120 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A first gate electrode 220 may be disposed on the first gate insulating layer 120 so as to overlap with the first semiconductor layer 210.

The first gate electrode 220 may be made of at least one of silver (Ag,) molybdenum (Mo), copper (Cu), titanium (Ti), aluminum (Al), chromium (Cr), nickel (Ni), neodymium (Nd), tungsten (W), and gold (Au). Embodiments of the present disclosure are not limited thereto.

A first metal layer 300 overlapping the switching transistor SW Tr, and a first capacitor electrode Cst1 of a pixel capacitor PXL Cst included in the pixel PXL may be disposed on the first gate insulating layer 120 in the display area AA. In the non-display area NA, a link wiring 650 may be disposed on the first gate insulating layer 120.

The first capacitor electrode Cst1, the first metal layer 300, and the link wiring 650 may be formed in the same process as a process in which the first gate electrode 220 is formed.

The first metal layer 300 may be driven by a lower gate electrode of the switching transistor SW Tr, or may be used as a light blocking layer that may prevent light from being reflected toward the second semiconductor layer 310 of the switching transistor SW Tr. Embodiments of the present disclosure are not limited thereto.

A second insulating layer 130 may be disposed on the first gate electrode 220, the first capacitor electrode Cst1, the first metal layer 300, and the first link wiring 650.

The second insulating layer 130 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A second capacitor electrode Cst2 of the pixel capacitor PXL Cst may be disposed on the second insulating layer 130. The second capacitor electrode Cst2 may be disposed to overlap the first capacitor electrode Cst1 and may be made of the same material as a material of the first capacitor electrode Cst1.

A second link wiring 651 may be disposed in the non-display area and on the second insulating layer 130 and may be formed in the same process as a process in which the second capacitor electrode Cst2 is formed.

A third insulating layer 140 may be disposed on the second capacitor electrode Cst2.

The third insulating layer 140 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

A second semiconductor layer 310 of the switching transistor SW Tr of the display area AA may be disposed on the third insulating layer 140.

The second semiconductor layer 310 may be made of a metal oxide semiconductor, such as indium-gallium-zinc-oxide (IGZO), indium-zinc-oxide (IZO), indium-gallium-tin-oxide (IGTO), and indium-gallium-oxide (IGO). However, the present disclosure is not limited thereto.

The metal oxide semiconductor may include a channel area where a channel through which electrons or holes migrate is formed, a source area, and a drain area.

For example, the conductive characteristics of the source and drain areas may be improved by a doping process that injects impurities. During an etching process to form the gate electrode on the metal oxide semiconductor, oxygen in an area of the metal oxide semiconductor that does not overlap with the gate electrode may be released to improve conductivity thereof such that the source and drain areas may become conductive. A source electrode and a drain electrode may be respectively connected to the source area and the drain area.

A second gate insulating layer 150 may be disposed on the second semiconductor layer 310, and a second gate electrode 320 may be disposed on the second gate insulating layer 150.

The second gate insulating layer 150 may be made of an insulating material such as silicon nitride (SiNₓ) or silicon oxide (SiOₓ), or may be made of an insulating inorganic material other than silicon nitride or silicon oxide or an insulating organic material. Embodiments of the present disclosure are not limited thereto.

The second gate electrode 320 may be disposed on the second gate insulating layer 150 so as to overlap the second semiconductor layer 310.

The second gate electrode 320 may be composed of a single layer or a multi-layer made of one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

A third link wiring 652 may be disposed on the second gate insulating layer 150 in the non-display area NA.

The first link wiring 650, the second link wiring 651, and the third link wiring 652 may extend to the display area AA and may apply a signal or a power voltage to the display area AA. The first link wiring 650, the second link wiring 651, and the third link wiring 652 may be connected to each other via a contact hole. However, embodiments of the present disclosure are not limited thereto.

The third link wiring 652 may be disposed under the dam area DM in the non-display area NA and may be disposed so as to at least partially overlap the dam area DM.

A fourth insulating layer 160 may be disposed on the second gate electrode 320 and the third link wiring 652. The fourth insulating layer 160 may be made of an insulating inorganic material such as silicon nitride (SiNₓ) or silicon oxide (SiOₓ), or may be made of one or more organic insulating materials such as BCB (BenzoCycloButene), acryl resin, epoxy resin, phenolic resin, polyamide resin, or polyimide resin. However, embodiments of the present disclosure are not limited thereto.

A first source electrode 230S and a first drain electrode 230D connected to the first semiconductor layer 210, and a second source electrode 330S and a second drain electrode 330D connected to the second semiconductor layer 310 may be disposed on the fourth insulating layer 160.

The first source electrode 230S and the first drain electrode 230D are connected to the first semiconductor layer 210 via contact holes extending through the first gate insulating layer 120, the second insulating layer 130, the third insulating layer 140, the second gate insulating layer 150, and the fourth insulating layer 160.

The second source electrode 330S and the second drain electrode 330D are connected to the second semiconductor layer 310 via contact holes extending through the second gate insulating layer 150 and the fourth insulating layer 160.

A fourth link wiring 654 may be disposed on the fourth insulating layer 160 in the non-display area NA. The fourth link wiring 654 may be formed in the same process as a process in which the first source electrode 230S, the first drain electrode 230D, the second source electrode 330S, and the second drain electrode 330D are formed.

Each of the first source electrode 230S, the first drain electrode 230D, the second source electrode 330S, the second drain electrode 330D, and the fourth link wiring 654 may be made of at least one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

The link wirings between the dam area DM of the non-display area NA and the display area AA may be electrically connected to each other via contact holes. The fourth link wiring 654 may be electrically connected to a fifth link wiring 630 and the third link wiring 652. However, embodiments of the present disclosure are not limited thereto.

A plurality of contact holes may be formed in the first connection area CoA1 of the non-display area NA so as to connect the link wiring and a driving signal bendable wiring 680 of the bendable area BA to each other. In the first connection area CoA1, the first link wiring 650 and the fourth link wiring 654 may be connected to each other via a contact hole, or the second link wiring 651 may be connected to the fourth link wiring 654 via a contact hole, and the third link wiring 652 may be connected to the fourth link wiring 654 via a contact hole. However, embodiments of the present disclosure are not limited thereto.

A first planarization layer 170 may be disposed on the first source electrode 230S, the first drain electrode 230D, the second source electrode 330S, the second drain electrode 330D, and the fourth link wiring 654.

The first planarization layer 170 may be embodied as an organic insulating layer made of, for example, polyacrylate or polyimide, and may reduce a step caused by underlying wirings and contact holes.

Due to the bending curvature of the display panel 10' in the bendable area BA, in the insulating film formed as the inorganic insulating film, cracks may occur. Thus, in the bendable area BA, the inorganic insulating film may be vulnerable to moisture penetration. For this reason, the inorganic insulating film in the bendable area BA vulnerable to moisture penetration may be entirely removed in an etching process.

When each of the buffer layer 111, the first insulating layer 110, the first gate insulating layer 120, the second insulating layer 130, the third insulating layer 140, the second gate insulating layer 150 and the fourth insulating layer 160 is embodied as the inorganic insulating film, each of the buffer layer 111, the first insulating layer 110, the first gate insulating layer 120, the second insulating layer 130, the third insulating layer 140, the second gate insulating layer 150 and the fourth insulating layer 160 may be removed in the bendable area BA in an etching process and may not be disposed in the bendable area BA.

A portion of the substrate 100 may be etched to control the bending curvature of the bendable area BA.

During the etching process, ends of the insulating layers may not be aligned with each other in a vertical manner such that the insulating layers may be stacked in a stepwise manner. However, embodiments of the present disclosure are not limited thereto.

The first planarization layer 170 may be in contact with the ends of the insulating layers and the substrate 100 in the bendable area BA.

A connection electrode 240 may be disposed on the first planarization layer 170 so as to connect the first drain electrode 230D and an anode electrode 600 to each other.

The connection electrode 240 may be electrically connected to the first drain electrode 230D via a contact hole formed in the first planarization layer 170.

On the first planarization layer 170, a fifth link wiring 630 and the driving signal bendable wiring 680 of the first connection area CoA1 and the bendable area BA may be disposed in the non-display area NA. The driving signal bendable wiring 680 may be connected to the fourth link wiring 654 via a contact hole and may extend into the bendable area BA so as to be electrically connected to the wirings of the pad wiring area PADA. The driving signal bendable wiring 680 may be referred to as the 'driving signal connection wire 680' or 'bending wire 680.'

Each of the connecting electrode 240, the fifth link wiring 630, and the driving signal bendable wiring 680 may be made of at least one of silver (Ag,) molybdenum (Mo), copper (Cu), titanium (Ti), aluminum (Al), chromium (Cr), nickel (Ni), neodymium (Nd), tungsten (W), and gold (Au) or an alloy thereof. Embodiments of the present disclosure are not limited thereto.

A second planarization layer 180 may be disposed on the connection electrode 240, the fifth link wiring 630, and the driving signal bendable wiring 680. The second planarization layer 180 may be embodied as an organic insulating layer made of, for example, polyacrylate or polyimide. Embodiments of the present disclosure are not limited thereto.

The second planarization layer 180 may be disposed on the first connection area CoA1 of the non-display area NA, and may be disposed on the driving signal bendable wiring 680 in the bendable area BA.

An anode electrode 600 may be disposed on the second planarization layer 180.

The anode electrode 600 may be electrically connected to the connection electrode 240 via a through hole formed in the second planarization layer 180. The anode electrode 600 may be made of at least one of silver (Ag), aluminum (Al), gold (Au), molybdenum (Mo), tungsten (W), chromium (Cr), lead (Pd), indium tin oxide (ITO), indium zinc oxide (IZO), or an alloy thereof. Embodiments of the present disclosure are not limited thereto.

A bank 190 may be disposed on the anode electrode 600 and the second planarization layer 180.

The bank 190 may distinguish a plurality of sub-pixels from each other, minimize light blurring, and prevent color mixing that occurs at various viewing angles.

The bank 190 may not cover a portion of the anode electrode 600 corresponding to a light-emitting area so as to be exposed, and may overlap an end of the anode electrode 600. The bank 190 may be made of an insulating inorganic material such as silicon nitride (SiNₓ) or silicon oxide (SiOₓ), or may be made of one or more organic insulating materials such as BCB (BenzoCycloButene), acryl resin, epoxy resin, phenolic resin, polyamide resin, or polyimide resin. However, embodiments of the present disclosure are not limited thereto.

A spacer 191 may be further disposed on the bank 190. The spacer 191 may maintain a gap between the substrate 100 on which a light-emitting element layer 610 has been formed and a touch unit and a cover window disposed on top thereof. Thus, When an external physical shock is applied thereto, damage to the elements inside the display panel may be minimized due to the gap. The spacer 191 may be made of the same material as a material of the bank 190, and may be formed in the same process as a process in which the bank 190 is formed. However, embodiments of the present disclosure are not limited thereto.

The light-emitting element layer 610 may be disposed in an opening of the bank 190 exposing the portion of the anode electrode 600. The light-emitting element layer 610 may include one or more of a red light-emitting layer, a green light-emitting layer, a blue light-emitting layer, and a white light-emitting layer in order to emit light of a specific color. Furthermore, the light-emitting element layer 610 may further include a hole injection layer, a hole transport layer, an electron transport layer, and an electron injection layer in addition to the organic light-emitting layer. However, embodiments of the present disclosure are not limited thereto.

The hole injection layer, the hole transport layer, the electron transport layer, and the electron injection layer may be individually disposed in each of the sub-pixels and may have different thicknesses and materials. Alternatively, each of the hole injection layer, the hole transport layer, the electron transport layer, and the electron injection layer may be commonly disposed in an entirety of the display area.

When the light-emitting element layer 610 includes the white organic light-emitting layer, the light-emitting element layer 610 may be disposed in the opening of the bank 190 and across an entirety of the substrate.

A color filter may be disposed on the light-emitting element layer 610 so as to convert light emitted from the white organic light-emitting layer into light of a different color other than white.

The cathode electrode 620 may be disposed on the light-emitting element layer 610. The cathode electrode 620 may supply electrons to the light-emitting element layer 610 and may be made of a conductive material with a low work function.

When the display device 10 operates in a top light emission scheme, the cathode electrode 620 may be made of a transparent conductive material that transmits light therethrough. For example, the cathode electrode 620 may be made of at least one of indium tin oxide (ITO) and indium zinc oxide (IZO). However, embodiments of the present disclosure are not limited thereto.

Alternatively, the cathode electrode 620 may be made of a translucent conductive material that transmits light therethrough. For example, the cathode electrode 620 may be made of at least one of following alloys: LiF/Al, CsF/Al, Mg:Ag, Ca/Ag, Ca:Ag, LiF/Mg:Ag, LiF/Ca/Ag, and LiF/Ca:Ag. However, embodiments of the present disclosure are not limited thereto.

When the display device 10 operates in a bottom light emission scheme, the cathode electrode 620 may be embodied as a reflective electrode that reflects light and may be made of an opaque conductive material. For example, the cathode electrode 620 may be made of at least one of silver (Ag), aluminum (Al), gold (Au), molybdenum (Mo), tungsten (W), chromium (Cr), or alloys thereof. However, embodiments of the present disclosure are not limited thereto.

In the non-display area NA, a driver circuit area and the dam area DM where a plurality of dams are disposed may be disposed.

The dam area DM may be an area where the driver circuit area of the display panel 10' and the pixel area PXL of the display area AA are sealed.

The dam area DM may include a plurality of dams such as a first dam DM1 and a second dam DM2.

The first dam DM1 may be deposited using the same material as that of each of the first planarization layer 170 and the bank 190, and in the same process as a process in which each of the first planarization layer 170 and the bank 190 is formed. The second dam DM2 may be deposited using the same material as that of each of the first planarization layer 170, the bank 190 and the spacer 191, and in the same process as a process in which each of the first planarization layer 170, the bank 190, and the spacer 191 is formed. However, embodiments of the present disclosure are not limited thereto.

The first dam DAM1 and the second dam DAM2 may have a first height and a second height, respectively, and may surround the display area AA.

The second dam DAM2 may be higher than the first dam DAM1. The second height may be larger than the first height. Although a second encapsulation layer 720 of an encapsulation layer 700, which will be described later extends over the first dam DM1 of the dam area DM, a second encapsulation layer 720 may not extend beyond the second dam DM2 in the dam area DM and may be blocked by the second dam DM2.

The first encapsulation layer 710 and the third encapsulation layer 730 of the encapsulation layer 700 may extend over the second dam DM2 to an outside area out of the dam area DM and may be disposed on the second planarization layer 180 in the first connection area CoA1.

The encapsulation layer 700 may be disposed on a portion of the cathode electrode 620 of the display area AA, a portion of the cathode electrode 620 of the non-display area NA, and the second dam DM2.

The encapsulation layer 700 may protect the display device 10 from external moisture, oxygen, or foreign substances. For example, the encapsulation layer 700 may prevent oxygen and moisture from penetrating from the outside into the display device to prevent oxidation of the light-emitting material and the electrode material.

The encapsulation layer 700 may be made of a transparent material to transmit light emitted from the light-emitting element layer 610 therethrough.

The encapsulation layer 700 may include the first encapsulation layer 710, the second encapsulation layer 720, and the third encapsulation layer 730 that block the penetration of moisture or oxygen. However, embodiments of the present disclosure are not limited thereto. The first encapsulation layer 710, the second encapsulation layer 720, and the third encapsulation layer 730 may be sequentially stacked. However, embodiments of the present disclosure are not limited thereto.

Each of the first encapsulation layer 710 and the third encapsulation layer 730 may be made of at least one inorganic material selected from silicon nitride (SiNₓ), silicon oxide (SiOₓ), or aluminum oxide (Al_{y}O_{z}). However, embodiments of the present disclosure are not limited thereto.

The second encapsulation layer 720 may cover foreign substances or particles that may be produced during the manufacturing process. Furthermore, the second encapsulation layer 720 may planarize a surface step of the first encapsulation layer 710.

The second encapsulation layer 720 may be made of an organic material such as silicon oxycarbide (SiOC), epoxy, polyimide, polyethylene, or acrylate-based polymer. However, embodiments of the present disclosure are not limited thereto.

A touch buffer layer 800 may be disposed on the third encapsulation layer 730. The touch buffer layer 800 may be disposed across an entirety of the display area AA and the non-display area NA, and may extend into a portion of the bendable area BA.

The touch buffer layer 800 may be made of at least one inorganic material selected from silicon nitride (SiNₓ), silicon oxide (SiOₓ), or aluminum oxide (Al_{y}O_{z}). However, embodiments of the present disclosure are not limited thereto.

A first touch electrode 810 may be disposed on the touch buffer layer 800.

Touch operation may be achieved by a plurality of sensing electrodes and a plurality of driving electrodes disposed in the display area AA. Each of the sensing electrodes may include a plurality of sub-sensing electrodes which extend along a first direction and are spaced from each other by a regular spacing along a second direction. The plurality of sensing electrodes may not break but may extend continuously in the first direction. The first direction and the second direction may intersect each other. For example, the first direction and the second direction may be perpendicular to each other.

Each of the plurality of driving electrodes may include a plurality of sub-driving electrodes which extend along the second direction and are spaced from each other by a regular spacing along the first direction. The plurality of sub-driving electrodes may be electrically connected to each other in the second direction.

When the plurality of sub-sensing electrodes and the plurality of sub-driving electrodes are formed in the same layer, the plurality of sub-driving electrodes may be electrically connected to each other through a bridge pattern. The plurality of sub-sensing electrodes and the plurality of sub-driving electrodes may have a metal mesh structure.

Additionally, the plurality of sub-sensing electrodes may be electrically connected to each other through a bridge pattern, and the plurality of sub-driving electrodes may not break but may extend continuously and may be electrically connected to each other.

The first touch electrode 810 may act as the plurality of sub-sensing electrodes, the plurality of sub-driving electrodes, or the bridge pattern.

The first touch electrode 810 may have a single-layer or multi-layer structure made of a metal material such as molybdenum (Mo), silver (Ag), titanium (Ti), copper (Cu), aluminum (Ti), titanium/aluminum/titanium (Ti/Al/Ti), or molybdenum/ aluminum/molybdenum (Mo/Al/Mo). However, embodiments of the present disclosure are not limited thereto.

A touch insulating layer 820 may be disposed on the first touch electrode 810. The touch insulating layer 820 may be disposed across an entirety of the display area AA and non-display area NA, and may be disposed so as to extend into a portion of the bendable area BA.

The touch insulating layer 820 may be made of at least one inorganic material selected from silicon nitride (SiNₓ), silicon oxide (SiOₓ), or aluminum oxide (Al_{y}O_{z}). However, embodiments of the present disclosure are not limited thereto.

A second touch electrode 830 may be disposed on the touch insulating layer 820. The second touch electrode 830 may act as the plurality of sub-sensing electrodes, the plurality of sub-driving electrodes, or the bridge pattern for touch operation.

In the same process as a process in which the second touch electrode 830 is formed, a touch line 840 for transmitting a touch driving signal to the non-display area NA may be formed.

Each of the second touch electrode 830 and the touch line 840 may have a single-layer or multi-layer structure made of a metal material such as molybdenum (Mo), silver (Ag), titanium (Ti), copper (Cu), aluminum (Ti), titanium/aluminum/titanium (Ti/Al/Ti), or molybdenum/ aluminum/molybdenum (Mo/Al/Mo). However, embodiments of the present disclosure are not limited thereto.

A third planarization layer 850 may be disposed on the second touch electrode 830 and the touch line 840.

The third planarization layer 850 may cover the second touch electrode 830, the touch line 840, and the touch insulating layer 820 and may perform planarization thereon. Furthermore, the third planarization layer 850 may be made of one or more organic insulating materials such as BCB (BenzoCycloButene), acryl resin, epoxy resin, phenolic resin, polyamide resin, or polyimide resin. However, embodiments of the present disclosure are not limited thereto.

The partitioning wall 940 may be disposed in the bendable area BA. The partitioning wall 940 may be formed in the same process as a process in which the third planarization layer 850 is formed, and may be disposed on the second planarization layer 180. The partitioning wall 940 may include a first partitioning wall 940_1, a second partitioning wall 940_2, and a third partitioning wall 940_3. The first partitioning wall 940_1 and the second partitioning wall 940_2 may be disposed in an area adjacent to the display area, and the third partitioning wall 940_3 may be disposed in an area adjacent to the pad wiring area PADA.

The first partitioning wall 940_1 may overlap and cover an end of each of the touch buffer layer 800 and the touch insulating layer 820 extending into a portion of the bendable area BA.

The touch buffer layer 800 and the touch insulating layer 820 may extend beyond an end of each of the buffer layer 111, the first insulating layer 110, the first gate insulating layer 120, the second insulating layer 130, the third insulating layer 140, the second gate insulating layer 150, and the fourth insulating layer 160 disposed under the first planarization layer 170 and then may extend into the bendable area BA.

External moisture may penetrate through the contact hole formed in the first connection area CoA1 of the bending area BA. Such moisture penetration may cause corrosion of the wiring of the first connection area CoA1 and reduce the reliability of the display device 10.

Since the touch buffer layer 800 and the touch insulating layer 820 may be disposed to extend into the bendable area BA, an external moisture infiltration path may further extend into the bendable area BA such that the moisture infiltration into the light emission area and the electrode area may be reduced.

A protective layer 860 may be disposed on the third planarization layer 850. The protective layer 860 may protect the display panel 10' from foreign substances or particles and may planarize the surface step of the display panel 10'. The protective layer 860 may be made of an organic material, for example, silicon oxycarbide (SiOC), or epoxy, polyimide, polyethylene, or acrylate-based polymer. However, the present disclosure is not limited thereto.

The protective layer 860 may extend beyond the third planarization layer 850 and may be disposed in a portion of the bendable area BA. The first partitioning wall 940_1 and the second partitioning wall 940_2 may prevent the protective layer 860 from extending into an area where the display panel 10' is substantially bent in the bendable area BA.

An adhesive layer 71 for attaching the display panel 10' and the cover window 80 to each other may be disposed on the protective layer 860.

FIG. 7 is a cross-sectional view of a display panel according to an embodiment of the present disclosure as cut along line C-C' in FIG. 4, and schematically shows the touch line 840 for transmitting the touch signal.

When describing the components in FIG. 7, descriptions of the components that are the same as or correspond to the components in FIG. 6 will be omitted or simplified.

The touch line 840 may extend to the non-display area NA while being disposed on the touch insulating layer 820 so as to overlap the dam area DM, and so as to be electrically connected to a touch bendable wiring 690 in the first connection area CoA1.

A contact hole may extend through the second planarization layer, the touch buffer layer 800, and the touch insulating layer 820 in the first connection area CoA1, so that the touch line 840 and the touch bendable wiring 690 may be connected to each other via the contact hole.

The touch bendable wiring 690 may be formed in the same layer as a layer of the driving signal bendable wiring 680 in FIG. 6, and may be formed in the same process as a process in which the driving signal bendable wiring 680 in FIG. 6 is formed.

The touch buffer layer 800 and the touch insulating layer 820 may extend beyond an end of the touch line 840 toward the bendable area BA and may be disposed to overlap the first partitioning wall 940_1.

An end of the touch line 840 may overlap the third planarization layer 850.

A display device according to some aspects and embodiments of the present disclosure may be set forth below as follows:

One aspect of the present disclosure provides a display device comprising: a substrate; a display area and a non-display area disposed on the substrate; a plurality of sub-pixels disposed in the display area, each sub-pixel including at least one transistor; a bendable area disposed in the non-display area; a connection area disposed between the bendable area and the display area; a light-emitting layer connected to the transistor; an encapsulation layer disposed on the light-emitting layer; a touch electrode disposed on the encapsulation layer; a touch planarization layer disposed on the touch electrode; and a partitioning wall disposed in the bendable area and adjacent to the connection area, wherein the partitioning wall and the touch planarization layer are made of the same material.

In accordance with some embodiments of the display device, the touch electrode includes a first touch electrode and a second touch electrode.

In accordance with some embodiments of the display device, a touch buffer layer is disposed on the encapsulation layer, wherein the first touch electrode is disposed on the touch buffer layer, wherein a touch insulating layer is disposed on the touch buffer layer and the first touch electrode, wherein the second touch electrode is disposed on the touch insulating layer.

In accordance with some embodiments of the display device, the connection area includes: a link wiring for transmitting a driving signal for driving the sub-pixel; and a touch line for transmitting a touch electrode signal.

In accordance with some embodiments of the display device, a dam is disposed in the non-display area, wherein the link wiring extends in the non-display area so as to be disposed under the dam and so as to partially overlap the dam.

In accordance with some embodiments of the display device, the touch line and the touch electrode are made of the same material.

In accordance with some embodiments of the display device, a driving signal bendable wiring and a touch bendable wiring are disposed in the bendable area, wherein a link wiring is connected to the driving signal bendable wiring, and the touch line is connected to the touch bendable wiring.

In accordance with some embodiments of the display device, the driving signal bendable wiring and the touch bendable wiring are disposed in the same layer.

In accordance with some embodiments of the display device, each of the touch buffer layer and the touch insulating layer overlaps at least a portion of the partitioning wall.

In accordance with some embodiments of the display device, the at least one transistor includes a driving transistor and a switching transistor, wherein at least one insulating film is disposed between a gate electrode of the driving transistor and a gate electrode of the switching transistor.

In accordance with some embodiments of the display device, an end of at least one insulating film is closer to the display area than an end of each of the touch buffer layer and the touch insulating layer.

In accordance with some embodiments of the display device, a display device further comprises a protective layer disposed on the touch planarization layer, wherein the protective layer partially contacts the partitioning wall.

In accordance with some embodiments of the display device, a display device further comprises a cover glass disposed on the protective layer, wherein an adhesive layer is disposed between the cover glass and the protective layer.

In accordance with some embodiments of the display device, a display device further comprise a bendable protective layer disposed in the bendable area, wherein the bendable protective layer overlaps the partitioning wall.

Although the embodiments of the present disclosure have been described in more detail with reference to the accompanying drawings, the present disclosure is not necessarily limited to these embodiments, and may be modified in a various manner within the scope of the present disclosure. Accordingly, the embodiments as disclosed in the present disclosure are intended to describe rather than limit the technical idea of the present disclosure, and the scope of the technical idea of the present disclosure is not limited by these embodiments. Therefore, it should be understood that the embodiments described above are not restrictive but illustrative in all respects.

## Claims

1. A display device (10') comprising:
a substrate including a display area (AA) and a non-display area (NA);
a plurality of sub-pixels (SP) disposed in the display area, each sub-pixel including at least one transistor (DR Tr, SW Tr);
a bendable area (BA) disposed in the non-display area;
a plurality of connection areas (CoA1) disposed in the non-display area, in which a contact hole for connecting wiring extending from the display area into the non-display area to bendable wiring of the bendable area is positioned;
a light-emitting layer (610) connected to the transistor;
an encapsulation layer (700) disposed on the light-emitting layer;
a touch electrode (810, 830) disposed on the encapsulation layer;
a partitioning wall (940) disposed in the bendable area and adjacent to the plurality of connection areas, and
a touch buffer layer (800) and a touch insulating layer (820) disposed on the encapsulation layer,
wherein the touch buffer layer and the touch insulating layer extend to the bendable area and overlap at least a portion of the partitioning wall.

2. The display device of claim 1, further comprising a touch planarization layer (850) disposed on the touch electrode.

3. The display device of claim 1 or 2, wherein the partitioning wall and the touch planarization layer are made of the same material.

4. The display device of any preceding claim, wherein the touch electrode includes a first touch electrode (810) and a second touch electrode (830).

5. The display device of any preceding claim, wherein one of the connection areas includes:
a driving signal bendable wiring (680) for driving the sub-pixel; and
a touch line (840) for transmitting a touch signal.

6. The display device of claim 5, wherein a dam (DM1) is disposed in the non-display area,
wherein the driving signal bendable wiring extends in the non-display area so as to be disposed under the dam and so as to partially overlap the dam.

7. The display device of claim 5 or 6, wherein the touch line and the touch electrode are made of the same material.

8. The display device of any of claims 5 to 7, wherein the driving signal bendable wiring and a touch bendable wiring (690) are disposed in the bendable area,
wherein a link wiring (650) is connected to the driving signal bendable wiring, and the touch line is connected to the touch bendable wiring, wherein the link wiring is configured to apply a signal or a power voltage to the display area,
and optionally wherein the driving signal bendable wiring and the touch bendable wiring are disposed in the same layer.

9. The display device of any preceding claim, wherein the at least one transistor includes a driving transistor (DR Tr) and a switching transistor (SW Tr),
wherein at least one insulating film is disposed between a gate electrode (220) of the driving transistor and a gate electrode (320) of the switching transistor.

10. The display device of claim 9, wherein an end of at least one insulating film is closer to the display area than an end of each of the touch buffer layer and the touch insulating layer.

11. The display device of any preceding claim, further comprising a protective layer (860) disposed on the touch planarization layer,
wherein the protective layer partially contacts the partitioning wall,
and optionally further comprising a cover glass disposed on the protective layer,
wherein an adhesive layer is disposed between the cover glass and the protective layer.

12. The display device of any preceding claim, further comprising a bendable protective layer (34) disposed in the bendable area,
wherein the bendable protective layer overlaps the partitioning wall.

13. The display device of any preceding claim, wherein the substrate (100) comprises a first substrate and a second substrate, and an intermediate layer between the first substrate and the second substrate.

14. The display device of claim 9 or any preceding claim when dependent on claim 9, further comprising a light blocking layer (200) disposed under the driving transistor.

## Patentansprüche

1. Anzeigevorrichtung (10'), umfassend:
ein Substrat, das einen Anzeigebereich (AA) und einen Nicht-Anzeigebereich (NA) aufweist;
mehrere Subpixel (SP), die in dem Anzeigebereich angeordnet sind, wobei jedes Subpixel mindestens einen Transistor (DR-Tr, SW-Tr) aufweist;
einen biegsamen Bereich (BA), der in dem Nicht-Anzeigebereich angeordnet ist;
mehrere Verbindungsbereiche (CoAl), die in dem Nicht-Anzeigebereich angeordnet sind und in denen ein Kontaktloch zum Verbinden von Verdrahtung, die sich von dem Anzeigebereich in den Nicht-Anzeigebereich erstreckt, mit biegsamer Verdrahtung des biegsamen Bereichs positioniert ist;
eine Leuchtschicht (610), die mit dem Transistor verbunden ist;
eine Verkapselungsschicht (700), die auf der Leuchtschicht angeordnet ist;
eine Berührungselektrode (810, 830), die auf der Verkapselungsschicht angeordnet ist;
eine Trennwand (940), die in dem biegsamen Bereich und benachbart zu den mehreren Verbindungsbereichen angeordnet ist, und
eine Berührungspufferschicht (800) und eine Berührungsisolationsschicht (820), die auf der Verkapselungsschicht angeordnet sind,
wobei sich die Berührungspufferschicht und die Berührungsisolationsschicht zu dem biegsamen Bereich erstrecken und mindestens einen Abschnitt der Trennwand überlappen.

2. Anzeigevorrichtung nach Anspruch 1, ferner umfassend eine Berührungsplanarisierungsschicht (850), die auf der Berührungselektrode angeordnet ist.

3. Anzeigevorrichtung nach Anspruch 1 oder 2, wobei die Trennwand und die Berührungsplanarisierungsschicht aus demselben Material hergestellt sind.

4. Anzeigevorrichtung nach einem der vorhergehenden Ansprüche, wobei die Berührungselektrode eine erste Berührungselektrode (810) und eine zweite Berührungselektrode (830) aufweist.

5. Anzeigevorrichtung nach einem der vorhergehenden Ansprüche, wobei einer der Verbindungsbereiche Folgendes aufweist:
eine biegsame Ansteuersignalverdrahtung (680) zum Ansteuern des Subpixels; und
eine Berührungsleitung (840) zum Übertragen eines Berührungssignals.

6. Anzeigevorrichtung nach Anspruch 5, wobei ein Damm (DM1) in dem Nicht-Anzeigebereich angeordnet ist,
wobei sich die biegsame Ansteuersignalverdrahtung in dem Nicht-Anzeigebereich so erstreckt, dass sie unter dem Damm angeordnet ist und den Damm teilweise überlappt.

7. Anzeigevorrichtung nach Anspruch 5 oder 6, wobei die Berührungsleitung und die Berührungselektrode aus demselben Material hergestellt sind.

8. Anzeigevorrichtung nach einem der Ansprüche 5 bis 7, wobei die biegsame Ansteuersignalverdrahtung und eine biegsame Berührungsverdrahtung (690) in dem biegsamen Bereich angeordnet sind,
wobei eine Link-Verdrahtung (650) mit der biegsamen Ansteuersignalverdrahtung verbunden ist und die Berührungsleitung mit der biegsamen Berührungsverdrahtung verbunden ist, wobei die Link-Verdrahtung dazu ausgelegt ist, ein Signal oder eine Leistungsspannung an den Anzeigebereich anzulegen,
und wobei optional die biegsame Ansteuersignalverdrahtung und die biegsame Berührungsverdrahtung in derselben Schicht angeordnet sind.

9. Anzeigevorrichtung nach einem der vorhergehenden Ansprüche, wobei der mindestens eine Transistor einen Treibertransistor (DR-Tr) und einen Schalttransistor (SW-Tr) aufweist,
wobei mindestens ein Isolationsfilm zwischen einer Gate-Elektrode (220) des Treibertransistors und einer Gate-Elektrode (320) des Schalttransistors angeordnet ist.

10. Anzeigevorrichtung nach Anspruch 9, wobei ein Ende mindestens eines Isolationsfilms näher an dem Anzeigebereich liegt als sowohl ein Ende der Berührungspufferschicht als auch der Berührungsisolationsschicht.

11. Anzeigevorrichtung nach einem der vorhergehenden Ansprüche, ferner umfassend eine Schutzschicht (860), die auf der Berührungsplanarisierungsschicht angeordnet ist, wobei die Schutzschicht die Trennwand teilweise kontaktiert,
und optional ferner umfassend ein Abdeckglas, das auf der Schutzschicht angeordnet ist,
wobei eine Klebeschicht zwischen dem Abdeckglas und der Schutzschicht angeordnet ist.

12. Anzeigevorrichtung nach einem der vorhergehenden Ansprüche, ferner umfassend eine biegsame Schutzschicht (34), die in dem biegsamen Bereich angeordnet ist, wobei die biegsame Schutzschicht die Trennwand überlappt.

13. Anzeigevorrichtung nach einem der vorhergehenden Ansprüche, wobei das Substrat (100) ein erstes Substrat und ein zweites Substrat und eine Zwischenschicht zwischen dem ersten Substrat und dem zweiten Substrat umfasst.

14. Anzeigevorrichtung nach Anspruch 9 oder einem der vorhergehenden Ansprüche, wenn abhängig von Anspruch 9, ferner umfassend eine Lichtsperrschicht (200), die unter dem Treibertransistor angeordnet ist.

## Revendications

1. Dispositif (10) d'affichage comprenant :
un substrat incluant une zone d'affichage (AA) et une zone hors affichage (NA) ;
une pluralité de sous-pixels (SP) disposés dans la zone d'affichage, chaque sous-pixel comprenant au moins un transistor (DR Tr, SW Tr) ;
une zone flexible (BA) disposée dans la zone hors affichage ;
une pluralité de zones de connexion (CoA1) disposées dans la zone hors affichage, dans lesquelles est positionné un trou de contact pour connecter un câblage s'étendant de la zone d'affichage jusque dans la zone hors affichage à un câblage flexible de la zone flexible ;
une couche électroluminescente (610) connectée au transistor ;
une couche (700) d'encapsulation disposée sur la couche électroluminescente ;
une électrode tactile (810, 830) disposée sur la couche d'encapsulation ;
une paroi (940) de séparation disposée dans la zone flexible et adjacente à la pluralité de zones de connexion, et
une couche tampon tactile (800) et une couche isolante tactile (820) disposée sur la couche d'encapsulation, la couche tampon tactile et la couche isolante tactile s'étendant jusqu'à la zone flexible et chevauchant au moins une partie de la paroi de séparation.

2. Dispositif d'affichage selon la revendication 1, comprenant en outre une couche tactile (850) de planarisation disposée sur l'électrode tactile.

3. Dispositif d'affichage selon la revendication 1 ou 2, la paroi de séparation et la couche tactile de planarisation étant constituées du même matériau.

4. Dispositif d'affichage selon l'une quelconque des revendications précédentes, l'électrode tactile incluant une première électrode tactile (810) et une seconde électrode tactile (830).

5. Dispositif d'affichage selon l'une quelconque des revendications précédentes, l'une des zones de connexion comprenant :
un câblage flexible (680) de signal d'attaque servant à attaquer le sous-pixel ; et
une ligne tactile (840) servant à transmettre un signal tactile.

6. Dispositif d'affichage selon la revendication 5, un barrage (DM1) étant disposé dans la zone hors affichage, le câblage flexible de signal d'attaque s'étendant dans la zone hors affichage de manière à être disposé sous le barrage et de manière à chevaucher partiellement le barrage.

7. Dispositif d'affichage selon la revendication 5 ou 6, la ligne de contact et l'électrode de contact étant constituées du même matériau.

8. Dispositif d'affichage selon l'une quelconque des revendications 5 à 7, le câblage flexible de signal d'attaque et un câblage flexible tactile (690) étant disposés dans la zone flexible,
un câblage (650) de liaison étant connecté au câblage flexible de signal d'attaque, et la ligne tactile étant connectée au câblage flexible tactile, le câblage de liaison étant configuré pour appliquer un signal ou une tension d'alimentation à la zone d'affichage,
et le câblage flexible de signal d'attaque et le câblage flexible tactile étant éventuellement disposés dans la même couche.

9. Dispositif d'affichage selon l'une quelconque des revendications précédentes, le ou les transistors comprenant un transistor de commande (DR Tr) et un transistor de commutation (SW Tr),
au moins un film isolant étant disposé entre une électrode (220) de grille du transistor de commande et une électrode (320) de grille du transistor de commutation.

10. Dispositif d'affichage selon la revendication 9, une extrémité d'au moins un film isolant étant plus proche de la zone d'affichage qu'une extrémité de chacune de la couche tampon tactile et de la couche isolante tactile.

11. Dispositif d'affichage selon l'une quelconque des revendications précédentes, comprenant en outre une couche protectrice (860) disposée sur la couche tactile de planarisation.
la couche protectrice étant en contact partiel avec la paroi de séparation,
et comprenant en outre éventuellement un verre de couverture disposé sur la couche protectrice,
une couche adhésive étant disposée entre le verre de couverture et la couche protectrice.

12. Dispositif d'affichage selon l'une quelconque des revendications précédentes, comprenant en outre une couche protectrice flexible (34) disposée dans la zone flexible,
la couche protectrice flexible chevauchant la paroi de séparation.

13. Dispositif d'affichage selon l'une quelconque des revendications précédentes, le substrat (100) comprenant un premier substrat et un second substrat, et une couche intermédiaire entre le premier substrat et le second substrat.

14. Dispositif d'affichage selon la revendication 9 ou l'une quelconque des revendications précédentes lorsqu'elle dépend de la revendication 9, comprenant en outre une couche (200) d'occultation de lumière disposée sous le transistor de commande.
